# EUROPEAN PATENT APPLICATION

(11) **EP 1 195 802 A1**
(43) Date of publication of application: **10.04.2002**
(21) Application number: 00121870.0
(22) Date of filing: 06.10.2000
(51) Int. Cl.: H01L 21/3213

(54) **Process for forming conductor lines on a semiconductor product**

(71) Applicant: Semiconductor300 GmbH & Co KG, 01099 Dresden (DE)
(72) Inventor: Morgenstern, Thomas, 01109 Dresden (DE); Poschenrieder, Bernhard, 01458 Ottendorf Okrilla (DE)
(74) Representative: Fischer, Volker, Dipl.-Ing.

(57) **Abstract**

Disclosed is a process for forming conductor lines on a semiconductor product by dry-etching a stack of an upper layer of a dielectric hardmask material, a medium layer of a conducting material containing tungsten and a lower layer of minor conductivity than the medium layer by etching both the upper layer and the medium layer with a first reactive etching component containing fluorine, overetching the tungsten containing layer selectively to the lower layer with a second reactive etching component containing C₂F₆ and etching the lower layer with a third reactive etching component containing another halogene than fluorine. Hexafluoric ethane is used to etch the tungsten containing layer highly selectively to a lower layer material like polysilicon. Furthermore, fluorine based etching components form polymers containing CF₂-chains on the tungsten containing layer, protecting it from polysilicon etching chemistry. Thereby undercuts of the polysilicon layer and undue pre-etching of the polysilicon layer during tungsten layer over-etching are avoided. As a consequence, conductor lines with precisely shaped vertical sidewalls are etched.

## Description

The present invention relates to a process for forming conductor lines on a semiconductor product by dry-etching the stack of an upper layer of a dielectric hardmask material, a medium layer of a conducting material containing tungsten and a lower layer of minor conductivity than the medium layer.

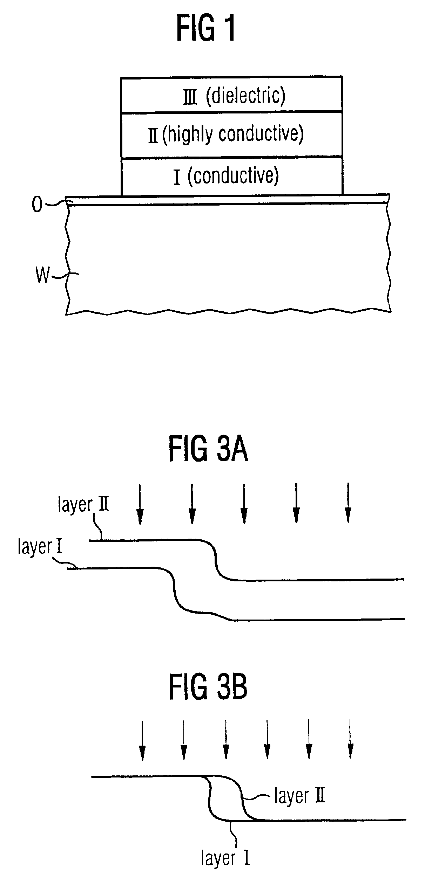

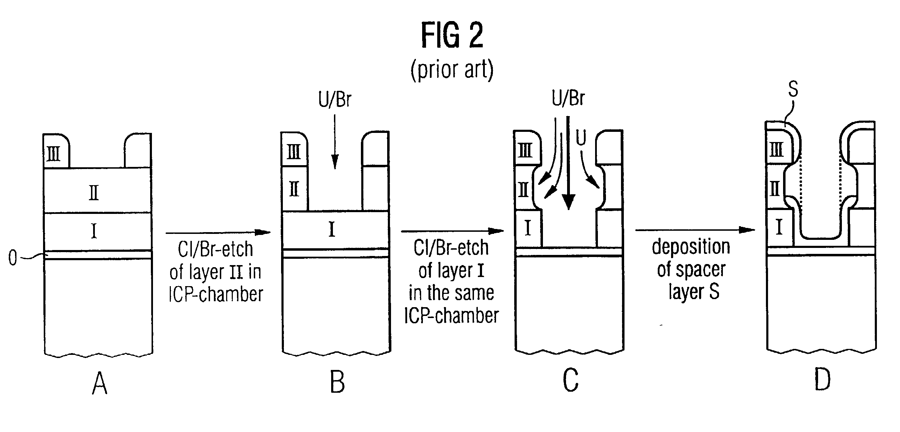

Current gate conductor lines as illustrated in figure 1 consist of a polysilicon layer I which is covered by a tungsten or at least tungsten containing layer II for improved electrical conductivity. In the manufacture of semiconductor products the polysilicon layer I, the tungsten containing layer II and a third layer III are deposited in sequence on one another. The third layer consists of a dielectric hardmask material used to pattern the tungsten containing layer and the polysilicon layer. In order to pattern the hardmask material III itself, it is coated with a resist layer which is patterned by common lithographic techniques.

The hardmask layer is patterned in an etching chamber, and the resist is stripped in an ash chamber.

This hardmask open etching is followed by forming conductor lines, that is by etching the tungsten containing layer II and the polysilicon layer I.

According to prior art etching illustrated in figure 2, both layers II and I are etched in the same chamber (an ICP chamber). As a consequence, the reactive etching components for etching the tungsten containing layer and the polysilicon layer have to be chosen such that no chamber contaminations occur when remainders of etching components for tungsten containing layer etching get into contact with etching components for polysilicon etching. For this reason both the tungsten containing layer II as well as the polysilicon layer I are etched with chlorine or bromine based chemistries.

According to this prior art etching process two problems occur.

First, when tungsten containing layer etching is finished (figure 2B) and the polysilicon layer is etched (figure 2C), the etching component for etching the polysilicon layer gets into contact with sidewalls of patterns of the tungsten containing layer. Hence, tungsten containing layer etching is continued during polysilicon layer etching.

Second, the polysilicon layer is already etched locally during etching of the tungsten containing layer due to an enhanced etching period due to over-etching. When a surface of a layer to be etched is planar there is a definite etching period corresponding to the etchrate and the thickness of the layer to be etched.

The surfaces of integrated circuit devices, however, are covered with recesses and elevations due to the structure of microelectronic devices. As a consequence, any layer deposited on microelectronic structures forms steps perpendicular to the surface to the semiconductor substrate as illustrated in figures 3A, 3B. Near the steps complete removal of a layer to be etched requires a longer etching period than etching planar regions of the layer. During the over-etching of this layer, the layer underneath is already etched in some degree by the etching component used for over-etching.

Hence, when the tungsten containing layer is over-etched, planar portions of the polysilicon layer already get into contact with the etching component for etching the tungsten containing layer. This pre-etching is disadvantageous with view to microelectronic device geometry.

These problems result from poor selectivity of the etching components, especially of chlorine based etching chemistry, when etching the tungsten containing layer selectively to the polysilicon layer or vice versa. However, as both layers are to be etched in the same etching chamber according to prior art, the variety of etching components is rather limited with view to the risk of contaminations of the etching chambers.

When conductor line stacks of a polysilicon layer and a tungsten containing layer are etched, poor selectivity of the etching components employed results in distorted etch profiles and incorrect shaping of the vertical sidewalls of the conductor line stacks produced. Especially etching the polysilicon layer I with chlorine based chemistry often causes undercuts of the tungsten containing layer II above, as illustrated in figure 2C.

Undercuts and other irregularities of the sidewalls of the conductor line stacks are responsible for short circuits in the integrated circuit. When conductor line etching is finished, the conductor line stack is covered with a thin spacer layer which has a typical thickness of 20 to 30 nm on the sidewalls of the conductor line structures etched before. Any protrusion or undercut in the sidewall produces gaps in the thin deposited spacer layer as illustrated in figure 2D. The spacer consisting of silicon nitride, for instance, serves to electrically insulate the conductor lines from contact-to-base lines formed between the conductor lines. Hence any gap in the insulating spacer leads to short circuits.

It is the object of the present invention to provide a process for forming conductor lines having vertical sidewalls free from undercuts or protrusions bearing the risk of electrical malfunctions.

This object is achieved by a process for forming conductor lines on a semiconductor product by dry-etching the stack of layers described above by etching both the upper layer and the medium layer with a first reactive etching component containing fluorine, over-etching the tungsten containing layer selectively to the lower layer with a second reactive etching component containing C₂F₆ and etching the lower layer with a third reactive etching component, containing another halogene than fluorine.

According to the invention, etching of the tungsten containing layer is combined with etching the hardmask (the upper layer) in a first etching chamber, allowing the usage of fluorine as etching component without the risk of contaminating a second polysilicon etching chamber. As a consequence, hexafluoric ethane, that is C₂F₆, which is capable of etching tungsten or tungsten silicide highly selectively to polysilicon, can be employed for over-etching the tungsten containing layer. Furthermore, fluorine based etching components form polymers containing CF₂-chains being deposited on the sidewalls of the tungsten containing layer and passivating it during polysilicon etching. Hence, neither polysilicon pre-etching caused during tungsten layer over-etching nor tungsten layer undercuts caused during polysilicon etching can occur. Hence, conductor line structures with vertical, precisely shaped sidewalls are formed.

According to preferred embodiments, the upper layer contains silicon nitride or an oxynitride or an oxide alternatively. After etching the conductor line structures, the dielectric hardmask material can be removed or, if required, be used for electrical conductor line insulation on top.

The medium layer preferably contains tungsten silicide or even elementary tungsten. Both materials grant for improved conductivity.

The first etching component for etching the upper and the medium layer preferably contains a substance CₓH_{y}F_{z}, preferably CHF₃ and/or CF₄. For example, mask layer opening can be performed by typical nitride etch components like CHF₃, oxygen and CF₄. Tungsten silicide main etch can be performed with CF₄.

After etching the upper and the medium layer, the medium layer over-etch is initiated in the same etching chamber by merely varying the kind and the gas flow of etching components supplied. Preferably, these steps are performed in a reactive ion etching chamber.

The lower layer preferably contains polysilicon, and the third etching component for etching the polysilicon layer preferably contains Cl₂ combined with HBr or HCl. Etching of the lower layer is performed in the same manner as in the prior art, except the fact that the tungsten or tungsten silicide layer is now passivated by polymers and thereby protected from any contact with the third etching component, hence no undercuts of the tungsten containing layer occur.

Preferably, the lower layer is over-etched selectively to an underground oxide material. Usually, the oxide material is silicon oxide of a thickness of about 5 nm, serving as gate oxide below the gate stacks shaped together with other conductor line structures.

Etching and over-etching the lower layer preferably are performed in an inductively coupled plasma etching chamber.

The thickness of the upper layer typically is between 150 and 250 nm, whereas the dimensions of the medium and the lower layer are 50 to 75 nm and 80 to 100 nm, respectively.

According to a preferred embodiment of the invention, the sidewalls of the conductor lines are covered with spacers of a thickness of preferrably 20 to 30 nm. The spacers comprise silicon nitride or another dielectric material.

After shaping conductor lines and covering them with spacers, recesses between spacers of conductor lines adjacent to each other are filled with an oxide that is locally replaced by electric contacts to base. These contacts are manufactured by means of common contact hole techniques.

Herein below the invention is described with reference to the figures 1 to 5.
- Figure 1: shows a conductor line stack to be etched by an etching process.
- Figure 2: schematically shows an etching process according to prior art.
- Figures 3A, 3B: illustrate the etching behaviour of a two layer stack adjacent to a step between regions different in height.
- Figures 4 and 5: schematically show an etching process according to the invention.

The layer stack illustrated in figure 1 is provided on a gate oxide layer O of a semiconductor wafer W and consists of two conducting layers I and II forming the actual conductor line. The layer II is provided for better conductivity. The conductor line is covered with a dielectric hardmask layer III serving to pattern the conductor line.

Whereas the conductor line stack in figure 1 is planar, in reality conductor line stacks are crossing a great number of microelectronic structures already provided on a semiconductor substrate. For this reason conductor line stacks provide a lot of steps between conductor line regions different in height. When a conductor line illustrated in figure 3A is etched, the thickness of the layer above (layer II) is greater than the thickness of this layer in planar regions of the conductor line. Hence, when the layer II is etched, planar regions of the layer underneath (layer I) are etched before the layer II adjacent to the step is completely removed. For this reason an overetch step for etching layer II selectively to layer I is required. Such overetch steps as such are well known, however, according to the present invention other overetching components are used than according to prior art.

According to a prior art etching process illustrated in figure 2 the etching steps leading to the semiconductor structures A, B and C are all performed in a single etching chamber. For this reason an etching chemistry based on other halogene etching components than fluorine (as chlorine or bromine, for instance) is employed to form both the structures B and C. After the hardmask layer III is etched (structure A), layers II (structure B) and I (structure C) are etched in the same etching chamber. As apparent from structure C, during etching of layer I the etching of layer II is continued because there always is a certain degree of anisotropy of the impinging etching component illustrated by the arrows above structure C. As a consequence, undercuts U are formed in the vertical sidewalls of layer II. When the thin insulating spacer layer S of a thickness of typically 20 to 30 nm is deposited, the undercuts are not covered by the layer S. Hence short circuits can occur when the gap between two adjacent gate conductor line stacks are filled with a conducting material.

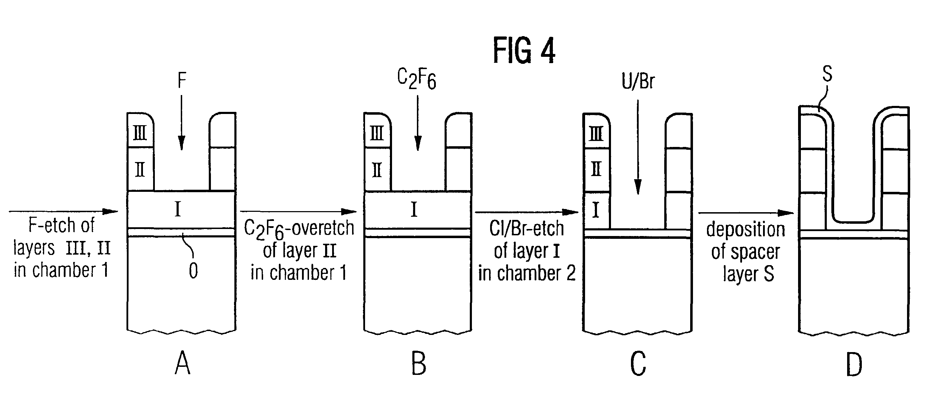

According to the etching process according to the invention illustrated in figure 4, layers III and II are etched in a first etching chamber 1 whereas layer I is etched in a second etching chamber 2. According to this etching process other etching components than according to prior art can be used.

Specifically, layers III and II are etched with etching components based on a fluorine chemistry (structure A), and the layer II (tungsten silicide or pure tungsten) overetch step is performed by using C₂F₆ (structure B) which is highly selective to layer I (polysilicon). During overetching of layer II, its sidewalls are covered with polymers containing CF2-chains. These polymers protect layer II from being etched when layer I is etched by etching components based on other halogenes than fluorine (structure C). For this reason, no undercuts are etched and no short circuits can occur when the spacer layer S is deposited (structure D).

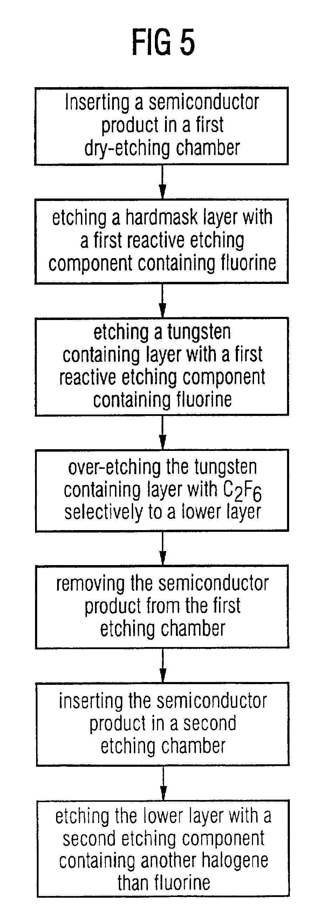

Figure 5 schematically illustrates the dry-etching process flow according to the invention. After inserting a semiconductor product in a first dry-etching chamber, the hardmask layer is etched with a first reactive etching component containing fluorine. According to the invention, the tungsten containing layer is etched in the same chamber with the first reactive etching component containing fluorine. Furthermore, a step of over-etching the tungsten containing layer with C₂F₆ selectively to the lower layer is performed in the same chamber.

In a second chamber, the lower layer is etched with a second etching component containing another hologene than fluorine. This step is performed in the same manner as according to prior art.

## Claims

1. The process for forming conductor lines on a semiconductor product by dry-etching a stack of
- an upper layer (III) of a dielectric hardmask material,
- a medium layer (II) of a conducting material containing tungsten and
- a lower layer (I) of minor conductivity than the medium layer by
- etching both the upper layer (III) and the medium layer (II) with a first reactive etching component containing fluorine,
- overetching the tungsten containing layer (II) selectively to the lower layer (I) with a second reactive etching component containing hexafluoric ethane and
- etching the lower layer (I) with a third reactive etching component containing another halogene than fluorine.

2. The process according to claim 1,
**characterized in**
**that** the upper layer (III) contains silicon nitride.

3. The process according to claim 1,
**characterized in**
**that** the upper layer (III) contains an oxinitride or an oxide.

4. The process according to one of claims 1 to 3,
**characterized in**
**that** the medium layer (II) contains tungsten silicide.

5. The process according to claim 4,
**characterized in**
**that** the medium layer (II) consists of tungsten.

6. The process according to one of claims 1 to 5,
**characterized in**
**that** the first etching component contains a substance CₓH_{y}F_{z}.

7. The process according to claim 6,
**characterized in**
**that** the first etching component contains CHF₃ and/or CF₄.

8. The process according to one of claims 1 to 7,
**characterized in**
**that** etching the upper and the medium layer and overetching the medium layer are performed in a reactive ion etching chamber.

9. The process according to one of claims 1 to 8,
**characterized in**
**that** the lower layer contains polysilicon.

10. The process according to one of claims 1 to 9,
**characterized in**
**that** the third etching component contains Cl₂ combined with HBr or HCl.

11. The process according to one of claims 1 to 10,
**characterized in**
**that** the lower layer is overetched selectively to an underground oxide material.

12. The process according to claim 11,
**characterized in**
**that** etching and overetching the lower layer are performed in an inductive coupled plasma etching chamber.

13. The process according to one of claims 1 to 12,
**characterized in**
**that** the thickness of the upper layer is between 150 and 250 nm.

14. The process according to one of claims 1 to 13,
**characterized in**
**that** the thickness of the medium layer is between 50 and 75 nm.

15. The process according to one of claims 1 to 14,
**characterized in**
**that** the thickness of the lower layer is between 80 and 100 nm.

16. The process according to one of claims 1 to 15,
**characterized in**
**that** sidewalls of the conductor lines are covered with spacers.

17. The process according to claim 16,
**characterized in**
**that** the thickness of the spacers is between 20 and 30 nm.

18. The process according to one of claims 16 to 17,
**characterized in**
**that** the spacers contain silicon nitride or another dielectric material.

19. The process according to one of claims 16 to 18,
**characterized in**
**that** recesses between spacers of adjacent conductor lines are filled with an oxide which is locally replaced by electric contacts to base.
